# EUROPEAN PATENT APPLICATION

(11) **EP 4 751 828 A1**
(43) Date of publication of application: **03.06.2026**
(21) Application number: 24845607.1
(22) Date of filing: 23.07.2024
(51) Int. Cl.: B23B 27/14, B23B 5/16, C23C 14/06

(54) **COATED CUTTING TOOL**

(30) Priority: 24.07.2023 JP 2023120108
(71) Applicant: Moldino Tool Engineering, Ltd., Tokyo 130-0026 (JP)
(72) Inventor: FUWA Ryoutarou, Yasu-shi, Shiga 520-2323 (JP)
(74) Representative: Hoffmann Eitle
(86) International application number: PCT/JP2024/026262
(87) International publication number: WO 2025/023232

(57) **Abstract**

Provided is a coated cutting tool in which a hard film is applied on a surface of a substrate. The hard film includes a layer A which is disposed on the surface of the substrate, contains W in the largest amount among metal elements including metalloids, followed by Ti, with a total content ratio of W and Ti of 70 atom% or more, and contains carbon in the largest amount among non-metal elements, followed by nitrogen, in which, in a case where a total content ratio of the metal elements including metalloids, carbon, nitrogen, and oxygen is set to 100 atom%, a ratio N_{A}/C_{A} of a nitrogen content ratio N_{A} to a carbon content ratio C_{A} is 0.40 or more, and which has a face-centered cubic lattice structure and a film thickness of 1 nm or more and 20 nm or less, and a layer B which is disposed on the layer A and has a face-centered cubic lattice structure formed of a nitride or carbonitride.

## Description

### TECHNICAL FIELD

The present invention relates to a coated cutting tool such as an end mill.

Priority is claimed on Japanese Patent Application No. 2023-120108, filed July 24, 2023, the content of which is incorporated herein by reference.

### BACKGROUND ART

A nitride or carbonitride of AlCrSi is a kind of film having excellent heat resistance and wear resistance, and is applied to coated cutting tools. The present inventors have proposed, as a tool which can be applied to milling of high-hardness steel, a coated cutting tool in which an intermediate film containing W and Ti with a face-centered cubic lattice structure is formed immediately above a substrate by Ti bombardment, and a nitride or carbonitride of AlCrSi whose film structure is made fine by increasing the Si content ratio is provided immediately thereabove (Patent Document 1).

### Citation List

### Patent Document

Patent Document 1: PCT International Publication No. WO2021/131232

### SUMMARY OF INVENTION

### Technical Problem

The coated cutting tool described in Patent Document 1 has excellent durability in cutting of high-hardness steel. Meanwhile, the present inventors have confirmed that there is room for improvement in adhesion with respect to the intermediate film formed by Ti bombardment.

### Solution to Problem

According to an aspect of the present invention, there is provided a coated cutting tool in which a hard film is applied on a surface of a substrate, in which the hard film includes a layer A which is disposed on the surface of the substrate, contains W in a largest amount among metal elements including metalloids, followed by Ti, with a total content ratio of W and Ti of 70 atom% or more, and contains carbon in a largest amount among non-metal elements, followed by nitrogen, in which, in a case where a total content ratio of the metal elements including metalloids, carbon, nitrogen, and oxygen is set to 100 atom%, a ratio N_{A}/C_{A} of a nitrogen content ratio N_{A} to a carbon content ratio C_{A} is 0.40 or more, and which has a face-centered cubic lattice structure and a film thickness of 1 nm or more and 20 nm or less, and a layer B which is disposed on the layer A and has a face-centered cubic lattice structure formed of a nitride or carbonitride.

In the layer A, in a case where the total content ratio of metal elements including metalloids, carbon, nitrogen, and oxygen is set to 100 atom%, a ratio N_{A}/M_{A} of the nitrogen content ratio N_{A} to a total content ratio M_{A} of the metal elements including metalloids is preferably 0.6 or more.

The layer B may be a nitride or carbonitride containing Al, Cr, and Si in which, among metal elements including metalloids, a content ratio of Al is 50 atom% or more and 65 atom% or less, a content ratio of Cr is 20 atom% or more and 40 atom% or less, a total content ratio of Al and Cr is 85 atom% or more and 96 atom% or less, and a content ratio of Si is 4 atom% or more and 15 atom% or less. In this case, in the layer B, in a case where a total of the metal elements and non-metal elements is set to 100%, an atomic ratio M_{B} of the metal elements including metalloids and an atomic ratio N_{B} of nitrogen may satisfy a relationship of 1.07 < N_{B}/ME_{B} < 1.30.

A layer C formed of a nitride or carbonitride of metal elements including metalloids may be further provided on the layer B.

The layer C may be a nitride or carbonitride in which, among the metal elements including metalloids, a content ratio of Ti is 60 atom% or more and 95 atom% or less, and a content ratio of Si is 5 atom% or more and 40 atom% or less.

### Advantageous Effects of Invention

According to one aspect of the present invention, a coated cutting tool having excellent durability is provided.

### BRIEF DESCRIPTION OF DRAWINGS

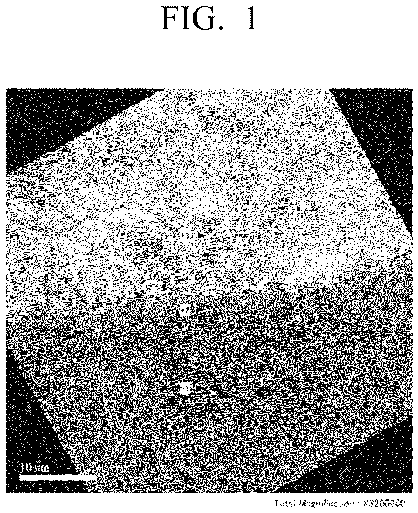

[FIG. 1] A transmission electron micrograph of a tool cutting edge portion of Example 1. In the drawing, a site indicated by reference numeral 1 is a substrate, a site indicated by reference numeral 2 is a layer A, and a site indicated by reference numeral 3 is a layer B.

### DESCRIPTION OF EMBODIMENTS

The present inventors have confirmed that, in a case where an intermediate film formed by Ti bombardment has a nitrogen content of a certain level or higher, the adhesion between a substrate and a hard film tends to be improved and the durability of a coated cutting tool is thus increased. Hereinafter, embodiments of the present invention will be described in detail.

A coated cutting tool according to the present embodiment includes a substrate, a layer A disposed on a surface of the substrate, and a layer B disposed on the layer A. In the coated cutting tool according to the present embodiment, the layer B is a hard film which imparts durability to the tool. The layer A is an intermediate film which improves the adhesion between the layer B and the substrate.

A WC-based cemented carbide substrate for a cutting tool is used as the substrate. The substrate may be a solid tool in which a head and a shank are formed integrally with each other, a head of a head-interchangeable tool, or a cutting insert mounted on a holder.

First, the layer A which is an intermediate film according to the present embodiment will be described.

The layer A is a Ti bombarded layer with a face-centered cubic lattice structure, which is provided between the substrate and the layer B with a face-centered cubic lattice structure formed of a nitride or carbonitride to be described later. In a case where the layer A disposed on the surface of the substrate has a face-centered cubic lattice structure (fcc structure), the layer B on the layer A is likely to maintain the face-centered cubic lattice structure (fcc structure), and the crystals of the substrate, the layer A, and the layer B are continuous, increasing the adhesion. In addition, it is thought that crystallinity of the layer B in the vicinity of the boundary with the layer A is further increased, and the adhesion between the substrate and the layer B is further increased.

The layer A is a Ti bombarded layer, is disposed on the surface of the substrate, and contains W in the largest amount among metal elements including metalloids (hereinafter, referred to as metal elements), followed by Ti, and a total content ratio of W and Ti is 70 atom% or more (hereinafter, simply referred to as %). **In** a case where the total content ratio of W and Ti among the metal elements is 70% or more, the crystal structure is stabilized in the layer A. The total content ratio of W and Ti is preferably 75% or more in the layer A.

The layer A contains carbon in the largest amount among non-metal elements, followed by nitrogen. The layer A may contain oxygen and argon as non-metal elements other than carbon and nitrogen. In a case where a total content ratio of the metal elements, carbon, nitrogen, and oxygen is set to 100%, a ratio N_{A}/C_{A} of a nitrogen content ratio N_{A} to a carbon content ratio C_{A} is 0.40 or more in the layer A. In a case where the layer A contains nitrogen at a certain ratio or more with respect to carbon, the adhesion to the layer B is increased, and the durability of the coated cutting tool is improved. That is, in the coated cutting tool according to the present embodiment, the layer A which has a face-centered cubic lattice structure (fcc structure) primarily containing W and Ti with the increased nitrogen content ratio is formed between the substrate and the layer B to improve the adhesion between the layer B and the substrate. N_{A}/C_{A} is preferably 0.45 or more. In addition, N_{A}/C_{A} is preferably 0.7 or less to stabilize the crystal structure of the layer A. N_{A}/C_{A} is more preferably 0.6 or less.

In a case where a total content ratio of the metal elements, carbon, nitrogen, and oxygen is set to 100%, a ratio N_{A}/M_{A} of the nitrogen content ratio N_{A} to a total content ratio M_{A} of the metal elements is preferably 0.6 or more in the layer A. The layer A preferably contains nitrogen at a certain ratio or more with respect to the metal elements, since the adhesion to the layer B is increased. N_{A}/M_{A} is preferably 0.7 or more. N_{A}/M_{A} is preferably 1.0 or less to stabilize the crystal structure of the layer A. N_{A}/M_{A} is more preferably 0.9 or less.

The layer A may contain a hard film component and a substrate component in addition to W and Ti. However, in order to stabilize the composition and the crystal structure of the layer A, a total content ratio of Al and Si among the metal elements is preferably 15% or less in the layer A. In a case where the content of Al and Si contained in the layer A is reduced, the composition and the crystal structure of the layer A are more likely to be stabilized. The total content ratio of Al and Si among the metal elements is preferably 10% or less in the layer A.

The layer A is likely to contain Co and Cr contained in the binding phase of the substrate. Even in a case where the layer A contains Co and Cr, a total content ratio of Co and Cr among the metal elements is preferably 15% or less. The total content ratio of Co and Cr among the metal elements is preferably 10% or less in the layer A.

The film thickness, composition, and crystal structure of the layer A can be confirmed by cross-sectional observation using a transmission electron microscope, composition analysis, and nano-beam diffraction patterns.

In a case where the layer A has a too small thickness, the adhesion to the substrate decreases. In addition, in a case where the layer A has an excessively large thickness, the adhesion to the substrate tends to decrease. Therefore, the thickness of the layer A is set to 1 nm or more and 20 nm or less. The thickness of the layer A is preferably set to 2 nm or more and 15 nm or less.

Next, the layer B which is a hard film of the present invention will be described.

The layer B is a hard film with a face-centered cubic lattice structure, which is provided on the above-described layer A and formed of a nitride or carbonitride. The hard film with a face-centered cubic lattice structure formed of a nitride or carbonitride has excellent wear resistance and heat resistance, and is widely applied to coated cutting tools. Among these, nitrides or carbonitrides primarily containing Al, Cr, and Ti are applied to coated cutting tools, and the layer B is preferably a nitride or carbonitride containing 80% or more of one or more of Al, Cr, and Ti in total. The material for the layer B is more preferably a nitride having excellent heat resistance. The layer B may be a single layer film or a laminated film in which a plurality of layers having different compositions are laminated.

In the coated cutting tool according to the present embodiment, it is important that the layer B has a face-centered cubic lattice structure (fcc structure). In the present embodiment, the face-centered cubic lattice structure (fcc structure) means that, in X-ray diffraction, a diffraction intensity due to a face-centered cubic lattice structure (fcc structure) is the maximum intensity. Since a hard film in which a diffraction intensity due to a hexagonal close-packed structure (hcp structure) is the maximum intensity is fragile, it has poor durability for a coated cutting tool. In particular, in wet processing, the durability tends to decrease.

In the layer B, it is preferable that a diffraction intensity due to a hexagonal close-packed structure (hcp structure) is not confirmed in X-ray diffraction. However, in a case where a diffraction intensity due to a face-centered cubic lattice structure (fcc structure) is the maximum intensity, the layer B may partially contain a hexagonal close-packed structure (hcp structure) and an amorphous phase.

In a case where a test area of the film is small or another film, which will be described later, is applied on the layer B, it may be difficult to identify the face-centered cubic lattice structure (fcc structure) by the above-described X-ray diffraction. In such a case, the crystal structure can be identified by a selected area diffraction method using a transmission electron microscope (TEM). It is preferable that the layer B has no peaks mainly due to the hexagonal crystal in the intensity profile obtained from the selected area diffraction pattern.

The layer B is preferably a nitride or carbonitride of AlCrSi, which is a kind of film having excellent heat resistance and wear resistance. Among these, nitrides or carbonitrides of AlCrSi having a large Si content ratio have a fine film structure, and thus it is possible to easily obtain the effect of improving adhesion in providing a Ti bombarded layer. Therefore, the layer B is preferably a nitride or carbonitride containing Al, Cr, and Si in which a content ratio of Al among the metal elements is 50% or more and 65% or less, a content ratio of Cr is 20% or more and 40% or less, a total content ratio of Al and Cr is 85% or more and 96% or less, and a content ratio of Si is 4% or more and 15% or less.

In a case where the layer B is a nitride or carbonitride of AlCrSi having a large Si content ratio, an atomic ratio M_{B} of metal elements including metalloids and an atomic ratio N_{B} of nitrogen preferably satisfy a relationship of 1.07 < N_{B}/M_{B} < 1.30 in a case where a total of the metal elements and non-metal elements in the layer B is set to 100%. It is possible to easily obtain the effect of improving adhesion by applying the layer A according to the present invention to the layer B having a high nitrogen content ratio.

The measurement of the composition of the layer B can be performed on a mirror-finished hard film using an electron probe microanalyzer (EPMA). In this case, for example, after the surface of the hard film is mirror-finished, analysis is performed at five points, each with an analysis range of about 1 µm in diameter, and the composition of the layer B can be determined from an average of the three points excluding the maximum value and the minimum value.

In a case where the layer B has a too small film thickness, excellent durability may not be sufficiently exhibited. In addition, in a case where the film thickness is too large, peeling of the film may occur. As the thickness of the layer B, for example, an appropriate value may be selected from a range of 0.5 µm or more and 10 µm or less. The thickness of the layer B is more preferably 1 µm or more. In addition, the thickness of the layer B is more preferably 5 µm or less.

In the present embodiment, the effects of the present embodiment are exhibited even in a case where another layer is further applied on the layer B. Therefore, the film structure formed of the layer A and the layer B in the present embodiment may adopt a configuration in which another layer is applied, other than the configuration in which the layer B is the outermost surface of the tool. In this case, a layer C formed of a nitride or carbonitride having excellent heat resistance and wear resistance is preferably applied on the layer B as a protective film. The layer C is more preferably formed of a nitride. The layer C is preferably a hard film having excellent thermal shock resistance and having a residual compressive stress. The composition of the layer C may be appropriately selected depending on the work material and processing conditions. In particular, in wet processing, since the hard film is likely to peel off due to the heating-cooling cycle, a hard film having a high residual compressive stress is preferably provided as a protective film.

The layer C is particularly preferably a nitride or carbonitride having a Ti content ratio of 60% or more and 95% or less and a Si content ratio of 5% or more and 40% or less from the viewpoint that it is a film type having high residual compressive stress.

The substrate is subjected to Ti bombardment to form the layer A according to the present embodiment on the substrate. A film forming device to be used for Ti bombardment preferably includes a cathode having a magnetic field configuration in which a coil magnet is provided on an outer periphery of the target to confine an arc spot inside the target. By performing a bombardment treatment with Ti, which is an elemental species that easily forms carbides, using such a cathode, oxides on the surface of the substrate are removed and cleaned. In addition, in addition to this cleaning, bombarded Ti ions diffuse into WC on the surface of the substrate, and a layer containing W and Ti is easily formed.

In the present embodiment, by forming the layer A containing W and Ti on a cutting edge, which is a functional portion, the adhesion between the substrate and the hard film on the cutting edge is increased, and the effect of increasing durability of the coated cutting tool can be obtained.

In a case where an absolute value of a negative bias voltage applied to the substrate during Ti bombardment is small or a current applied to the target is low, it is difficult to form the layer containing W and Ti on the surface of the substrate. Therefore, the negative bias voltage applied to the substrate is preferably set to -1000 V or lower and -700 V or higher. Also, the current applied to the target is preferably set to 80 A or more and 150 A or less. The temperature in the furnace is preferably 400°C or higher and 800°C or lower. The Ti bombardment is preferably performed by introducing a nitrogen gas into a vacuum container at 5 to 50 sccm.

According to the studies by the present inventors, it has been confirmed that the thickness of the layer A formed on the tool cutting edge is influenced by a difference in shape such as a tool diameter and a cutting edge shape.

### Examples

### <Substrate>

As a substrate, a 2-flute ball end mill made of a cemented carbide having a composition of WC (bal.)-Co (8 mass%)-Cr (0.5 mass%)-VC (0.3 mass%), an average WC particle size of 0.6 µm, and a hardness of 93.9 HRA was prepared.

### <Manufacturing Method>

An arc ion plating type film forming device was used for film formation. The device includes a plurality of cathodes (arc evaporation sources), a vacuum container, and a substrate rotation mechanism.

The cathodes include one cathode in which a coil magnet is provided on an outer periphery of a target (hereinafter, referred to as "C1"), and two cathodes in which permanent magnets are provided on a back surface and the outer periphery of the target and a magnetic field generation coil generating a magnetic field is further provided in front of the target to push plasma forward (hereinafter, referred to as "C2" and "C3"). The distance from the surface of the target to the substrate is 400 mm.

Inside air in the vacuum container is exhausted by a vacuum pump, and a gas is introduced thereto from a supply port. A bias power supply is connected to the substrate installed in the vacuum container, and a negative bias voltage is independently applied to the substrate.

A work table, a plate-shaped jig on the work table, and a pipe-shaped jig on the plate-shaped jig are attached to the substrate rotation mechanism. The work table rotates at a speed of 3 revolutions per minute, and the plate-shaped jig and the pipe-shaped jig revolve themselves. A metallic Ti target was installed in C1, an AlCrSi alloy target was installed in C2, and a TiSi alloy target was installed in C3.

### <Heating and Vacuum Exhaust Step>

Each substrate was fixed to the pipe-shaped jig in a vacuum container, and a pre-film formation process was performed as follows. First, the inside of the vacuum container was vacuum-exhausted to 5 × 10⁻³ Pa or lower. After that, the substrate was heated by a heater installed in the vacuum container until a substrate temperature reached 500°C, and vacuum exhaust was performed. Therefore, the substrate temperature was 500°C, and the pressure in the vacuum container was 5 × 10⁻³ Pa or less.

### <Ar Bombardment Step>

After that, an Ar gas was introduced into the vacuum container, and the pressure inside the container was set to 0.50 Pa. After that, a current of 30 A was supplied to a filament electrode, a negative bias voltage of -150 V was applied to the substrate, and Ar bombardment was performed for 60 minutes.

### <Ti Bombardment Step>

After that, a nitrogen gas was introduced into the vacuum container at 30 sccm, and the pressure inside the container was set to 0.3 Pa. After that, a current of 90 A was supplied to the metallic Ti target, a negative bias voltage of -800 V was applied to the substrate, and Ti bombardment was performed for 15 minutes.

### <Film Formation Step>

After Ti bombardment, a nitrogen gas was introduced into the vacuum container, and the pressure inside the vacuum container was set to 4 Pa. An Al60Cr30Si10 target (the numerical values each indicate an atomic ratio, the same applies hereinafter) was supplied with a current of 100 A, the magnetic field generation coil was supplied with a current of 5 A, and a negative bias voltage of -150 V was applied to the substrate to apply a hard film of a nitride having a film thickness of about 2 µm. Next, a Ti75Si25 target was supplied with a current of 150 A, the magnetic field generation coil was supplied with a current of 5 A, and a negative bias voltage of -50 V was applied to the substrate to apply an upper layer of a nitride having a film thickness of about 1 µm.

In the conventional coating, in Ti bombardment, an Ar gas was introduced into the vacuum container at 30 sccm, and the pressure inside the container was set to 0.3 Pa. After that, a current of 90 A was supplied to the Ti target, a negative bias voltage of -800 V was applied to the substrate, and Ti bombardment was performed for 15 minutes. The hard film forming conditions were the same as those in Example.

In order to confirm the film structure of the layer A, a cross section of the cutting edge portion of the ball end mill was observed using a field emission transmission electron microscope (JEM-2010F manufactured by JEOL Ltd.). The sample was cut and bonded onto a dummy substrate by using an epoxy resin. After that, cutting, Mo-manufactured reinforcing ring adhesion, polishing, dimpling, and Ar ion milling were performed to prepare a sample for measurement. Carbon deposition was performed before measurement. The observation, composition analysis, and nano-beam diffraction were performed with an acceleration voltage of 200 kV.

The composition of the layer A was obtained by energy dispersive X-ray spectroscopy (EDS). For the nano-beam diffraction, the camera length was set to 50 cm, and the region around the center of the film thickness was analyzed with a beam diameter of about 0.2 nm. The analysis results are shown in Table 1.

**[Table 1]**

| | Diffraction Pattern Analysis Result | EXD Analysis Result (atom%) | | | | | | | | | N_{A}/C_{A} | N_{A}/M_{A} |
|---|---|---|---|---|---|---|---|---|---|---|---|---|
| | Crystal Structure | C | N | O | A1 | Si | Ti | Cr | Co | W | | |
| Example 1 | (W, Ti)C₁₋ₓCubic | 45 | 22 | 4 | 2 | 1 | 6 | 2 | 1 | 17 | 0.49 | 0.76 |
| Comparative Example 1 | (W, Ti)C₁₋ₓCubic | 49 | 16 | 2 | 1 | 1 | 7 | 2 | 1 | 21 | 0.33 | 0.48 |

The composition of the layer B was measured by wavelength-dispersive electron probe microanalysis (WDS-EPMA) attached to an electron probe microanalyzer (JXA-8500F manufactured by JEOL Ltd.). In a mirror-finished sample, measurement was performed at five points where each analysis region was about 1 µm in diameter under conditions of an acceleration voltage of 10 kV, an irradiation current of 5 × 10⁻⁸ A, and an acquisition time of 10 seconds.

The average composition of the layer B was (Al56Cr33Si11)N, and N_{B}/M_{B} was 1.20. In addition, it was confirmed that the layer B had no peaks mainly due to the hexagonal crystal in the intensity profile obtained from the selected area diffraction pattern.

### (Conditions) Drying

Tool: 2-flute carbide ball end mill
Model number: EPDBE2010-6, ball radius 0.5 mm
Cutting method: Bottom cutting
Work material: STAVAX (52 HRC) (manufactured by Bohler-Uddeholm Co., Ltd.)
Depth of cut: 0.04 mm in an axial direction, 0.04 mm in a radial direction
Cutting speed: 75.4 m/min
One blade feed amount: 0.0179 mm/blade
Cutting distance: 15 m
Evaluation method: After cutting, the work material was observed using a scanning electron microscope at a magnification of 1000 times to measure widths of abrasion between the tool and the work material on a flank face of the tool, and a portion having the largest abrasion width thereamong was defined as a flank face maximum wear width.

**[Table 2]**

| | Flank Face Maximum Wear Width (µm) |
|---|---|
| Example 1 | 8 |
| Comparative Example 1 | 14 |

In Example 1, the layer A had a high nitrogen content ratio, and more excellent adhesion was exhibited. In the above-described Example, a nitride of AlCrSi having a large Si content ratio, which tends to have a fine film structure and poor adhesion, is applied to the layer B, but the effect of improving the adhesion can be achieved even in a case where the layer B has another composition.

## Claims

1. A coated cutting tool in which a hard film is applied on a surface of a substrate,
wherein the hard film includes
a layer A which is disposed on the surface of the substrate, contains W in a largest amount among metal elements including metalloids, followed by Ti, with a total content ratio of W and Ti of 70 atom% or more, and contains carbon in a largest amount among non-metal elements, followed by nitrogen,
in which, in a case where a total content ratio of the metal elements including metalloids, carbon, nitrogen, and oxygen is set to 100 atom%, a ratio N_{A}/C_{A} of a nitrogen content ratio N_{A} to a carbon content ratio C_{A} is 0.40 or more, and which has a face-centered cubic lattice structure and a film thickness of 1 nm or more and 20 nm or less, and
a layer B which is disposed on the layer A and has a face-centered cubic lattice structure formed of a nitride or carbonitride.

2. The coated cutting tool according to Claim 1, wherein in the layer A, in a case where the total content ratio of metal elements including metalloids, carbon, nitrogen, and oxygen is set to 100 atom%, a ratio N_{A}/M_{A} of the nitrogen content ratio N_{A} to a total content ratio M_{A} of the metal elements including metalloids is 0.6 or more.

3. The coated cutting tool according to Claim 1 or 2, wherein the layer B is a nitride or carbonitride containing Al, Cr, and Si in which, among metal elements including metalloids, a content ratio of Al is 50 atom% or more and 65 atom% or less, a content ratio of Cr is 20 atom% or more and 40 atom% or less, a total content ratio of Al and Cr is 85 atom% or more and 96 atom% or less, and a content ratio of Si is 4 atom% or more and 15 atom% or less.

4. The coated cutting tool according to Claim 3, wherein in the layer B, in a case where a total of the metal elements and non-metal elements is set to 100%, an atomic ratio M_{B} of the metal elements including metalloids and an atomic ratio N_{B} of nitrogen satisfy a relationship of 1.07 < N_{B}/M_{B} < 1.30.

5. The coated cutting tool according to Claim 1, wherein a layer C formed of a nitride or carbonitride of metal elements including metalloids is further provided on the layer B.

6. The coated cutting tool according to Claim 5, wherein the layer C is formed of a nitride or carbonitride in which, among the metal elements including metalloids, a content ratio of Ti is 60 atom% or more and 95 atom% or less, and a content ratio of Si is 5 atom% or more and 40 atom% or less.
